# EUROPEAN PATENT SPECIFICATION

(11) **EP 3 262 909 B1**
(45) Date of publication and mention of the grant of the patent: **30.09.2020**
(21) Application number: 16756437.6
(22) Date of filing: 26.02.2016
(51) Int. Cl.: F28D 15/02, H01L 23/467, H01L 23/427, H01L 23/38, H01L 23/367

(54) **HEAT SINKS INCLUDING HEAT PIPES AND RELATED METHODS**
KÜHLKÖRPER MIT WÄRMEROHREN UND ZUGEHÖRIGE VERFAHREN
DISSIPATEURS THERMIQUES COMPRENANT DES CALODUCS ET PROCÉDÉS CONNEXES

(30) Priority: 27.02.2015 US 201562121746 P; 27.03.2015 US 201514671078
(43) Date of publication of application: 03.01.2018
(73) Proprietor: Laird Thermal Systems, Inc., Morrisville, NC 27560 (US)
(72) Inventor: KARLSTEDT, Dan Martin Gustav, Earth City, Missouri 63045 (US); SEIBERLICH, Johan Henrik, Earth City, Missouri 63045 (US); HÖJER, Ulf Henrik Julius, Earth City, Missouri 63045 (US)
(74) Representative: AWA Sweden AB
(86) International application number: PCT/US2016/019756
(87) International publication number: WO 2016/138371

(56) References cited:
- EP-A1- 2 363 882
- JP-A- 2002 076 219
- JP-A- 2005 106 381
- JP-A- 2008 072 062
- US-A- 5 629 560
- US-A- 5 756 931
- US-A1- 2003 131 970
- US-A1- 2004 050 535
- US-A1- 2004 050 535
- US-A1- 2004 245 866
- US-A1- 2005 257 532
- US-A1- 2007 177 354
- US-A1- 2007 251 675
- US-A1- 2009 145 581
- US-A1- 2011 108 237
- US-A1- 2012 006 514
- US-A1- 2012 057 300
- US-A1- 2014 338 858
- US-B1- 6 173 576

## Description

### FIELD

The present disclosure generally relates to heat sinks including heat pipes and methods of making and operating heat sinks.

### BACKGROUND

This section provides background information related to the present disclosure which is not necessarily prior art.

Heat sinks may be used to transfer heat from devices to cool the devices. For example, thermoelectric modules (TEMs) may be coupled to heat sinks. Heat pipes may be used with heat sinks to reduce thermal resistance of the heat sinks. Fans may be used to direct air across the heat sinks to increase the cooling efficiency of the heat sinks. The prior art includes the fan module and the base seat therefor disclosed in US 2014/338858, the cooling device for cooling a heat-generating element disclosed in US 5756931, the heat dissipating device for supplying cold airflow disclosed in EP 2363882, and the cooling unit for an integrated circuit package disclosed in US 6173576.

### SUMMARY

This section provides a general summary of the disclosure, and is not a comprehensive disclosure of its full scope or all of its features.

According to various aspects, exemplary embodiments are disclosed of heat sinks and methods of making and operating heat sinks. In an exemplary embodiment, a heat sink generally includes at least one thermally conductive material and a fan configured to provide an air flow across the thermally conductive material with a non-uniform distribution such that one or more sections of the thermally conductive material have an increased air flow from the fan. The heat sink also includes at least one heat pipe disposed substantially within the thermally conductive material. The at least one heat pipe is angled towards the one or more sections of the thermally conductive material having the increased air flow from the fan.

In another exemplary embodiment, a method of making a heat sink is disclosed. The exemplary method generally includes positioning a fan relative to a surface of a thermal plate such that the fan will provide increased air flow across one or more portions of the surface of the thermal plate, and positioning at least one heat pipe substantially within the thermal plate at an angle towards the one or more portions of the thermal plate receiving an increased air flow from the fan.

In a further exemplary embodiment, a method of cooling a heat sink having an angled heat pipe disposed within a thermal material is disclosed. The exemplary method generally includes rotating an impingement fan to direct increased air flow across one or more portions of the thermal material receiving the angled heat pipe, and less air flow across one or more other portions that do not receive the angled heat pipe.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.
FIG. 1 is a block diagram of an example heat sink having a fan that provides a non-uniform airflow distribution;
FIG. 2 is a block diagram of an exemplary embodiment of a heat sink that includes four heat pipes oriented or angled for spreading heat to areas of the heat sink having the highest cooling effect due to the non-uniform air velocity created by the fan over the heat sink;
FIG. 3 includes a top view and a side view of another exemplary embodiment of a heat sink that includes four heat pipes having bent ends protruding upwardly in the heat sink; and
FIG. 4 is a table illustrating various example heat sink configurations and their performance characteristics.

Corresponding reference numerals indicate corresponding parts throughout the several views of the drawings

### DETAILED DESCRIPTION

Example embodiments will now be described more fully with reference to the accompanying drawings.

The inventors have recognized that air velocity over the surface of a heat sink (*e.g.,* thermally conductive material, thermal plate, thermal material, *etc.*) caused by rotation of a fan (*e.g.,* an impingement fan, *etc.*) may not be uniform. Orienting the heat pipes to spread heat to the area(s) of the heat sink which have the highest cooling effect due to the non-uniform air velocity can increase the cooling effectiveness of the heat sink (*e.g.,* reduce the thermal resistance of the heat sink, *etc*.). For example, angled heat pipes may be used in the bottom plate of the heat sink to spread the heat to the areas of the heat sink where the fan gives the most airflow. Due to the rotation of an impingement fan, the air velocity may be highest at the two edges of the heat sink where the fan is releasing air in the rotation direction of the fan. Thus, thermal resistance of the heat sink may be reduced by using heat pipes in the area(s) of the heat sink having the most air flow.

The inventors have also recognized that configuring (*e.g.,* bending, angling, *etc.*) the heat pipes at the end to protrude upwards in the heat sink can further increase the cooling effectiveness of the heat sink. The end of the heat pipe may be the hottest part of the heat pipe. Thus, bending or angling the end of the heat pipe may place the end of the heat pipe in the direct airflow of the fan. For example, the heat pipe may be bent at each end of the heat pipe, may be bent at approximately a ninety degree angle, *etc.*

The present invention is defined by the heat sink according to claim 1, the method of making the heat sink according to claim 11 and the method of using the heat sink according to claim 15. In an exemplary embodiment, a heat sink generally includes at least one thermally conductive material and a fan configured to rotate air over the thermally conductive material with a non-uniform distribution such that one or more sections of the thermally conductive material have an increased air flow from the fan. The heat sink also includes at least one heat pipe disposed substantially within the thermally conductive material. The at least one heat pipe is angled towards the one or more sections of the thermally conductive material having the increased air flow from the fan.

The thermally conductive material may be any material suitable for transferring heat from one or more heat generating components (*e.g.,* electronics, devices, boards, processors, circuits, *etc.*) to cool the component(s), keep the component(s) from overheating, protect the component(s) from being damaged, cause the component(s) to operate more efficiently, operate faster, *etc.* Example thermally conductive materials include thermal plates, thermal materials having one or more fins, *etc.* The thermally conductive material may be shaped and sized to any desired dimensions (*e.g.,* rectangular, square, *etc.*) which may correspond to a size of a heat generating component coupled to the thermally conductive material. The size (*e.g.,* length, width, height, *etc.*) and type of thermally conductive material may be selected to provide sufficient cooling capability to a heat generating component. By way of example, the thermally conductive material of the heat sink may be aluminum or copper, *etc.* The heat sink comprises extruded fins or skived fins.

The heat pipes may be any pipes suitable for transferring heat from a heat generating component, through the thermally conductive material, *etc.* The heat pipes may be inserted into the thermally conductive material, formed integrally or integrated with the thermally conductive material, *etc.* The heat pipes may be sized (*e.g.,* diameter, length, *etc*.) and shaped (*e.g.,* circular, rectangular, *etc*.) to the desired application such that the heat pipes are capable of providing sufficient heat transfer. The heat pipes may be solid, may have a hollow interior, *etc.,* and may be made of a material sufficient to transfer adequate heat for the application. By way of example, the heat pipes may be made out copper, stainless steel, nickel, aluminum, brass, *etc.* Also by way of example, the heat pipes may be hollow and used with a working fluid in some embodiments. In such embodiments, the working fluid may comprise water, alcohol, Ethane, Freon 22, Freon 21, Freon 11 Pentane, Freon 113, Acetone, Methanol, Flutec PP2, Heptane, Toluene, Flutec PP9, *etc.*

The fan is suitable for directing, rotating, *etc.* air across the thermally conductive material. The fan is an impingement fan, which is configured to direct air downwards towards a top surface of the thermally conductive material as the fan rotates. The fan may provide a non-uniform (*e.g*., ununiformed, *etc.*) air flow such that the air velocity is different across different portions of the heat sink. For example, the air velocity may be higher at edges of the thermally conductive material that are in the rotation direction of the fan. Edges in the rotation direction may receive more air velocity, while edges opposite the rotation direction may receive less air velocity.

The heat pipes may be positioned (*e.g*., disposed, angled, oriented, *etc.)* such that the heat pipes occupy areas of the thermally conductive material that receive a higher air velocity from the fan. For example, the heat pipes may be directed toward edges of the thermally conductive material that are in the direction of rotation of the fan. Some heat pipes may be angled at approximately forty-five degrees to one or more sides of the thermally conductive material. In some embodiments, the air velocity may be higher in a first direction on a first side of the thermally conductive material and higher in a second opposite direction on a second opposite side of the thermally conductive material. Thus, the heat pipe may be angled so that a first end of the heat pipe is adjacent the higher air velocity portion on the first side of the thermally conductive material, and a second opposite end of the heat pipe is adjacent the higher air velocity portion on the second opposite side of the thermally conductive material.

In some example embodiments, the heat pipe may have one or more bends or angled portions (*e.g.,* the heat pipe may be bent in one or more locations on the heat pipe, *etc*.)*.* For example, an end of the heat pipe may be bent upwards in the thermally conductive material. The heat pipe may be bent upwards at both ends. Any suitable bend angle may be used, including a ninety degree angle, less than a ninety degree angle, more than a ninety degree angle, *etc.* Bending an end of the heat pipe upwards may provide increased cooling as the bent end extends into an increased airflow from the fan, *etc.* An end of the heat pipe may be the hottest part, and may be bent upwards into direct airflow of the fan.

The heat pipe is substantially contained within the thermally conductive material, such that no portions of the heat pipe protrude from the thermally conductive material (*e.g.,* no ends of the heat pipe stick out from the thermally conductive material, the heat pipe does not extend beyond an outer surface of the thermally conductive material, *etc.*)*.* For example, the heat pipe may be positioned adjacent a bottom surface of the thermally conductive material. One or more ends of the heat pipe may be bent upwards adjacent a side of the thermally conductive material. A bottom portion of the pipe and one or more bent ends of the heat pipe may be positioned within the bottom surface and side surface(s) of the thermally conductive material, such that the heat pipe does not extend beyond those surfaces (*e.g*., protrude from the surfaces, *etc.*)*.*

The heat sink may include any suitable number of heat pipes. The number of heat pipes may be selected to provide adequate cooling characteristics, and may be selected based on the size of the thermally conductive material, the amount of heat required to be transferred by the heat sink, type of thermally conductive material, the type of heat pipe material, the size of the heat pipes, *etc.* In some embodiments, the heat sink may include four heat pipes. Other embodiments may include more or less heat pipes.

The thermally conductive material is coupled to one or more thermoelectric modules (TEMs). The thermoelectric modules are coupled to the heat sink to transfer heat away from the thermoelectric modules. Any suitable thermoelectric modules may be used with the heat sink. In some exemplary embodiments, there may be two or more thermoelectric coolers aligned in a row. In such exemplary embodiments, heat pipes are integrated into a heat sink, which is used to transfer heat away from the thermoelectric coolers. The heat pipes are angled to improve (*e.g.,* maximize, increase, *etc.*) heat spreading to thereby improve cooling capacity (*e.g.,* 50% improvement in cooling capacity, *etc*.)*.*

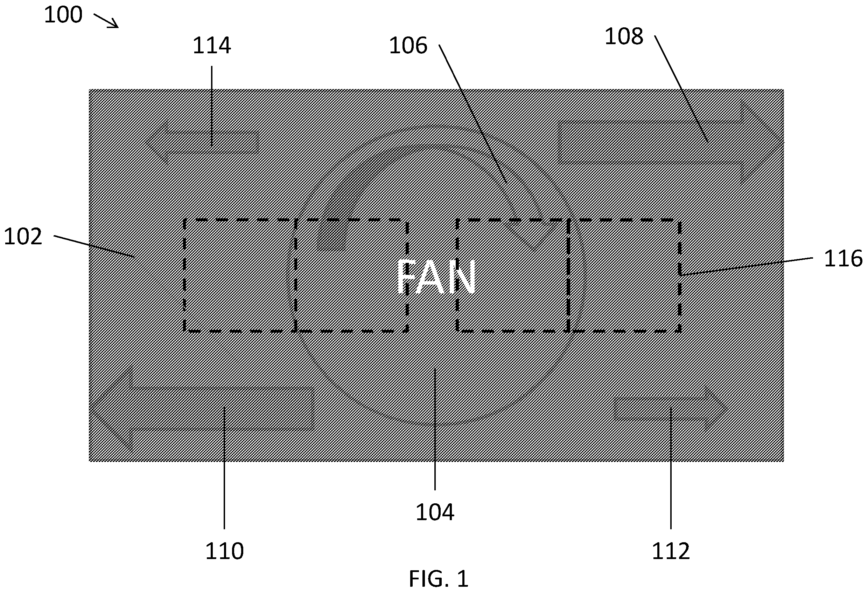

With reference to the figures, FIG. 1 illustrates a heat sink 100 not part of the present invention, that does not include any heat pipes. The heat sink 100 includes a thermally conductive material 102 (which may include one or more fins (not shown)) and a fan 104, which may be an impingement fan, *etc.* The fan 104 rotates in a clockwise direction as indicated by arrow 106, to provide airflow to the thermally conductive material 102 for cooling the heat sink 100.

Due to the clockwise direction of rotation 106 of the fan 104, an increased airflow exits the fan at an upper right portion of the thermally conductive material 102. This increased airflow is shown by the larger arrow 108. Similarly, an increased airflow also occurs at the lower left portion of the thermally conductive material 102 as indicated by the larger arrow 110. These portions receive increased airflow because the airflow is in the direction of rotation 106 of the fan 104.

The lower right portion of the thermally conductive material 102 receives a decreased airflow as compared to the upper right portion, which is indicated by the arrow 112 being smaller than the arrow 108. Similarly, the upper left portion of the thermally conductive material 102 receives a decreased airflow as compared to the lower left portion as indicated by the arrow 114 being smaller than the arrow 110. Thus, the airflow in directions 112 and 114 may be less than the airflow in directions 108 and 110, because the airflow directions 112 and 114 are opposite of the direction of rotation 106 of the fan 104.

FIG. 1 also illustrates two thermoelectric modules 116, which are shown in phantom dotted lines. The thermoelectric modules 116 may be coupled to a bottom side of the thermally conductive material 102, which may be opposite the fan 104.

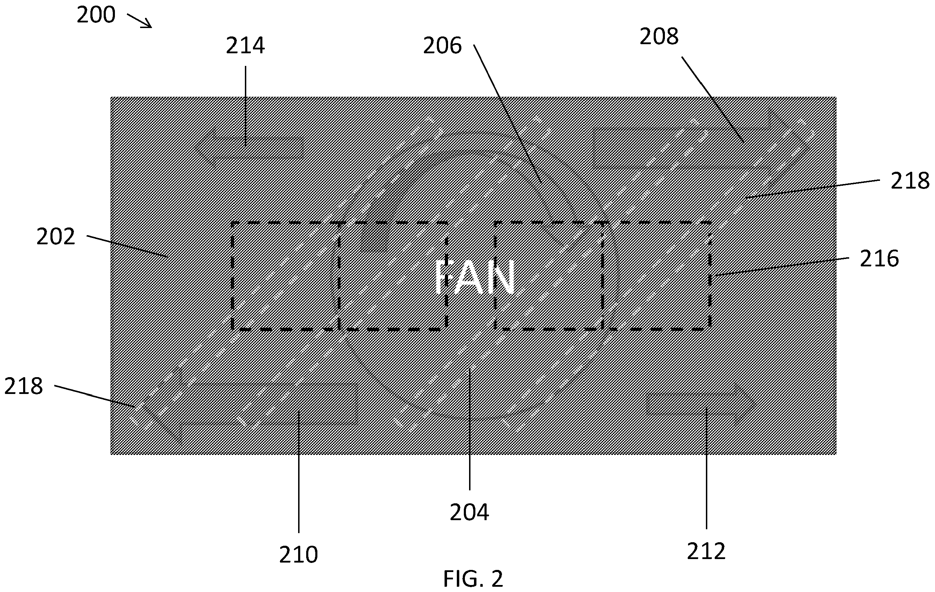

FIG. 2 illustrates an exemplary embodiment of a heat sink 200 embodying one or more aspects of the present disclosure. As shown in FIG. 2, the heat sink 200 includes a thermally conductive material 202 (which includes one or more fins (not shown)) and a fan 204, which is an impingement fan. The heat sink 200 also includes four heat pipes 218. As disclosed herein, the heat pipes 218 are angled for spreading heat to areas of the heat sink 200 having the highest cooling effect due to the non-uniform air velocity created by the fan 204 over the heat sink 200. FIG. 2 also illustrates two thermoelectric modules 216, which are shown in phantom dotted lines. The thermoelectric modules 216 may be coupled to a bottom side of the thermally conductive material 202, which may be opposite the fan 204.

The fan 204 rotates in a clockwise direction as indicated by arrow 206, to provide airflow to the thermally conductive material 202 for cooling the heat sink 200. Due to the clockwise direction of rotation 206 of the fan 204, an increased airflow exits the fan at an upper right portion of the thermally conductive material 202. This increased airflow is shown by the larger arrow 208. Similarly, an increased airflow also occurs at the lower left portion of the thermally conductive material 202 as indicated by the larger arrow 210. These portions receive increased airflow because the airflow is in the direction of rotation 206 of the fan 204.

The lower right portion of the thermally conductive material 202 receives a decreased airflow as compared to the upper right portion, which is indicated by the arrow 212 being smaller than the arrow 208. Similarly, the upper left portion of the thermally conductive material 202 receives a decreased airflow as compared to the lower left portion as indicated by the arrow 214 being smaller than the arrow 210. Thus, the airflow in directions 212 and 214 may be less than the airflow in directions 208 and 210, because the airflow directions 212 and 214 are opposite of the direction of rotation 206 of the fan 204.

The heat pipes 218 may be any suitable heat pipes, and are positioned within the thermally conductive material 202 (as shown by the dotted lines). The heat pipes 218 are angled at approximately forty-five degrees to receive an increased airflow from the fan 204. For example, the upper ends of the heat pipes 218 are angled towards the increased airflow 208 and away from the decreased airflow 214, such that the heat pipes 218 will receive more of the increased airflow 208 and less of the decreased airflow 214. Similarly, the lower ends of the heat pipes 218 are angled towards the increased airflow 210 and away from the decreased airflow 212, such that the heat pipes 218 will receive more of the increased airflow 210 and less of the decreased airflow 212.

Angling the heat pipes 218 in these directions places more of the heat pipes 218 in areas of the thermally conductive material 202 that receive increased airflow from the fan 204. Thus, the heat pipes 218 are angled in a direction of rotation 206 of the fan 204. This increases the cooling of the heat pipes 218 because the heat pipes 218 receive increased airflow as compared to a heat sink having heat pipes that are not angled towards portions of the thermally conductive material receiving an increased air flow.

Although FIG. 2 illustrates four heat pipes 218 angled at approximately forty-five degrees with respect to the sides of the thermally conductive material 202, other embodiments may include more or less heat pipes 218, heat pipes 218 having different angles with respect to the sides of the thermally conductive material 202, *etc.* FIG. 2 illustrates a single fan 204 that rotates in a clockwise direction 206. Other embodiments may include more than one fan 204, fan(s) 204 that rotate in other directions (*e.g.,* counterclockwise, *etc*.)*,* fans that have increased airflow in other portions of the thermally conductive material, *etc.*

The heat sink 200 illustrates a single thermally conductive material 202. Other embodiments may include more than one thermally conductive material 202, a thermally conductive material 202 formed from multiple sections, *etc.* The heat sink 200 also includes two thermoelectric modules 216. Other embodiments, may include more or less thermoelectric modules (or none), may include other heat generating components, *etc.*

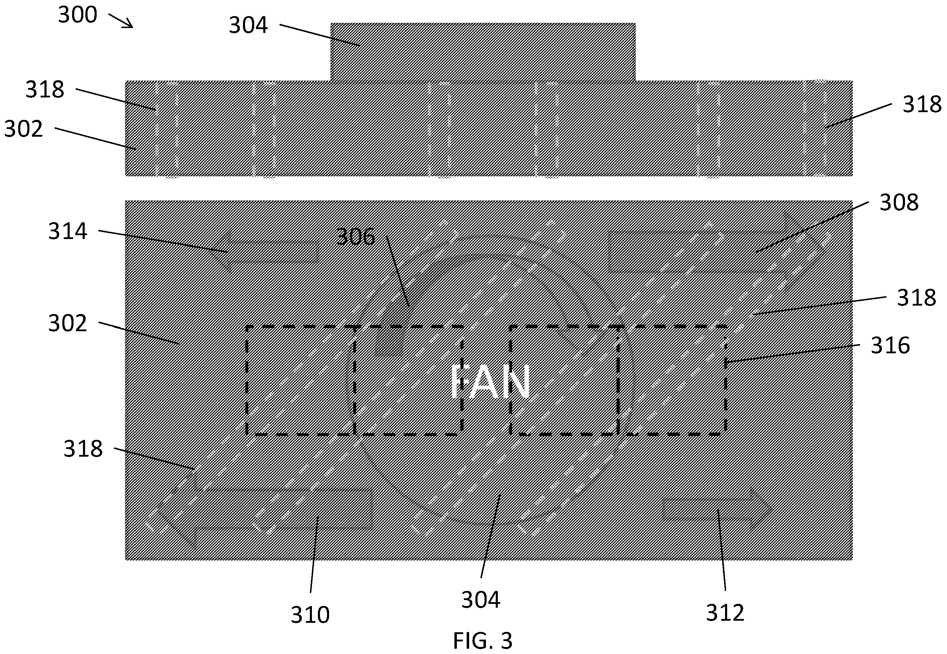

FIG. 3 illustrates another exemplary embodiment of a heat sink 300 embodying one or more aspects of the present disclosure. As shown in FIG. 3, the heat sink 300 includes a thermally conductive material 302 (which may include one or more fins (not shown)) and a fan 304, which may be an impingement fan, *etc.* The heat sink 300 also includes four heat pipes 318.

The heat pipes 318 are oriented or angled for spreading heat to areas of the heat sink 300 having the highest cooling effect due to the non-uniform air velocity created by the fan 304 over the heat sink 300. In this exemplary embodiment, the heat pipes 318 are bent or angled upwards at their ends. As shown in the side view of FIG. 3, the ends of the heat pipes 318 extend upwards through the thermally conductive material 302.

The fan 304 rotates in a clockwise direction as indicated by arrow 306, to provide airflow to the thermally conductive material 302 for cooling the heat sink 300. Due to the clockwise direction of rotation 306 of the fan 304, an increased airflow exits the fan at an upper right portion 308 and lower left portion 310 of the thermally conductive material 302. The lower right portion 312 and upper left portion 314 f the thermally conductive material 302 receive a decreased airflow as compared to the upper right and lower left portions 308, 310.

The heat pipes 318 may be any suitable heat pipes, and are positioned within the thermally conductive material 302 (as shown by the dotted lines). The heat pipes 318 are angled at approximately forty-five degrees to receive an increased airflow from the fan 304. For example, the upper ends of the heat pipes 318 are angled towards the increased airflow 308 and away from the decreased airflow 314, such that the heat pipes 318 will receive more of the increased airflow 308 and less of the decreased airflow 314. Similarly, the lower ends of the heat pipes 318 are angled towards the increased airflow 310 and away from the decreased airflow 312, such that the heat pipes 318 will receive more of the increased airflow 310 and less of the decreased airflow 312.

Angling the heat pipes 318 in these directions places more of the heat pipes 318 in areas of the thermally conductive material 302 that receive increased airflow from the fan 304. Thus, the heat pipes 318 are angled in a direction of rotation 306 of the fan 304. This increases the cooling of the heat pipes 318 because the heat pipes 318 receive increased airflow as compared to a heat sink having heat pipes that are not angled towards portions of the thermally conductive material receiving an increased air flow.

As illustrated in the side view of FIG. 3, the ends of the heat pipes 318 are bent, angled, and/or extend upwards through the thermally conductive material 302. The top view illustrates only six upward extensions of the ends of heat pipes 318 because the front ends of the two heat pipes 318 on the right overlap with the back ends of the two heat pipes 318 on the left, when viewing from the side as shown in the top of FIG. 3.

FIG. 3 illustrates the ends of the heat pipes 318 extending up to the top surface of the thermally conductive material 302, but not beyond the top surface (*e.g.,* the ends of the heat pipes 318 do not protrude from the thermally conductive material 302, *etc*.)*.* In other embodiments, the heat pipes 318 may extend upwards to a point below the surface of the thermally conductive material 302.

As shown in FIG. 3, the ends of the heat pipes 318 are adjacent the sides and corners of the thermally conductive material 302. Other embodiments may include heat pipes 318 having ends that are not adjacent the sides, corners, *etc.* of the thermally conductive material 302 (*e.g.,* the ends of the heat pipes 318 may be more centrally located in the thermally conductive material 302 away from the sides, *etc*.)*.*

Although FIG. 3 illustrates four heat pipes 318 angled at approximately forty-five degrees with respect to the sides of the thermally conductive material 302, other embodiments may include more or less heat pipes 318, heat pipes 318 having different angles with respect to the sides of the thermally conductive material 302, *etc.* FIG. 3 illustrates a single fan 304 that rotates in a clockwise direction 306. Other embodiments may include more than one fan 304, fan(s) 304 that rotate in other directions (*e.g.,* counterclockwise, *etc.*)*,* fans that have increased airflow in other portions of the thermally conductive material, *etc.*

The heat sink 300 illustrates a single thermally conductive material 302. Other embodiments may include more than one thermally conductive material 302, a thermally conductive material 302 formed from multiple sections, *etc.* The heat sink 300 also includes two thermoelectric modules 316. Other embodiments, may include more or less thermoelectric modules (or none), may include other heat generating components, *etc.*

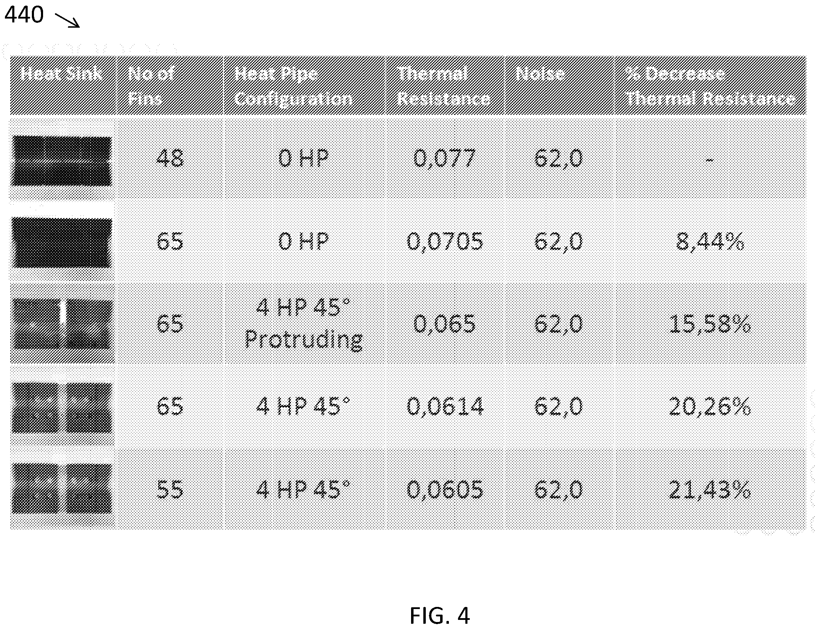

FIG. 4 illustrates a table 440 showing characteristics of different heat sink configurations including conventional heat sinks without any heat pipes for comparison with exemplary embodiments of heat sinks having heat pipes as disclosed herein. For example, a conventional heat sink having 48 fins and no heat pipes may have a thermal resistance of approximately 0.077 K/W; whereas a conventional heat sink having 65 fins and zero heat pipes may have a thermal resistance of approximately 0.0705 K/W (about 8.44% less than the 48 fin heat sink case). By comparison, an exemplary embodiment of a heat sink having 65 fins and four heat pipes that protrude from the thermally conductive material and are at approximately a forty-five degree angle with the sides of the thermally conductive material may have a thermal resistance of approximately 0.065 K/W (about 15.58% less than the 48 fin heat sink case). Another exemplary embodiment of a heat sink having 65 fins and four heat pipes that do not protrude from the thermally conductive material and are at approximately a forty-five degree angle with the sides of the thermally conductive material may have a thermal resistance of approximately 0.0614 K/W (about 20.26% less than the 48 fin heat sink without any heat pipes). Another exemplary embodiment of heat sink having 55 fins and four heat pipes that do not protrude from the thermally conductive material and are at approximately a forty-five degree angle with the sides of the thermally conductive material may have a thermal resistance of approximately 0.0605 K/W (about 21.43% less than the 48 fin heat sink without any heat pipes). The noise for each heat sink was 62 dB(A). The values set forth in table 440 are provided only for purpose of illustration only and not for purpose of limitation as other exemplary embodiments may be configured differently, *e.g*., have more or less fins, have more or less heat pipes, have a different heat pipe configuration, have a different thermal resistance, *etc.*

According to another example embodiment, an exemplary method of making a heat sink is disclosed. The exemplary method generally includes positioning a fan above a top surface of a thermal plate (*e.g.,* thermally conductive material, *etc.)* such that the fan will provide increased air flow to one or more portions of the top surface of the thermally conductive material. The method also includes positioning at least one heat pipe substantially within the thermal plate at an angle towards the one or more portions of the thermal plate receiving an increased air flow from the fan.

Positioning the heat pipe may include inserting the heat pipe into the thermal plate, forming or integrating the heat pipe within the thermal plate, *etc.* Positioning the heat pipe may include positioning the heat pipe at approximately a forty-five degree angle relative to a side of the thermal plate.

The method may include bending or angling a first end of the heat pipe upward to extend vertically through the thermal plate. The method may also include bending or angling a second end of the heat pipe upward to extend vertically through the thermal plate. The second end of the heat pipe may be opposite the first end of the at least one heat pipe. The method may include coupling a thermoelectric module to the thermal plate.

According to another example embodiment, a method of cooling a heat sink having an angled pipe disposed within a thermal material (*e.g.,* a thermal plate, a thermally conductive material, *etc*.) is disclosed. The method generally includes rotating an impingement fan to direct increased air flow to one or more portions of the thermal material receiving the angled heat pipe, and less air flow to one or more portions that do not receive the angled heat pipe.

Some embodiments may provide one or more advantages, including increased cooling of the heat sink, directing increased airflow to heat pipes, directing increased airflow to end portions of the heat pipes, reduced thermal resistance of the heat sink, reduction in the number of fins needed for a heat sink, *etc.*

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purposes of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e*., the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc.*)*.* As used herein, the term "and/or" includes any and all combinations of one or more of the associated listed items.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A heat sink (200; 300) comprising:
at least one thermally conductive material (202; 302) having a top surface and a bottom plate, the thermally conductive material (202; 302) including extruded fins or skived fins;
an impingement fan (204; 304) configured to direct air downwards toward the top surface of the thermally conductive material (202; 302) so that air flow of the impingement fan (204; 304) is redirected, from a downward direction, horizontally across the thermally conductive material (202; 302), thereby providing the air flow horizontally across the thermally conductive material (202; 302) with a non-uniform distribution such that opposite first and second sections of the thermally conductive material (202; 302) that are in a rotation direction of the impingement fan (204; 304) receive more air velocity to have an increased air flow from the impingement fan (204; 304);
at least one thermoelectric module (216; 316) coupled to the thermally conductive material (202; 302); and
at least one heat pipe (218; 318), substantially all of the heat pipe (218; 318) disposed within the bottom plate of the thermally conductive material (202; 302), the at least one heat pipe (218; 318) being angled horizontally towards the first and second sections of the thermally conductive material (202; 302) having the increased air flow from the impingement fan (204; 304),
wherein the at least one heat pipe (218; 318) includes opposite first and second end portions adjacent to the first and second sections, respectively, of the thermally conductive material (202; 302) having the increased air flow from the impingement fan (204; 304), thereby allowing the at least one heat pipe (218; 318) to spread heat to the first and second sections of the thermally conductive material (202; 302) having the increased air flow and reduce thermal resistance of the heat sink (200; 300).

2. The heat sink (200; 300) of claim 1, wherein the at least one heat pipe (218; 318) is disposed adjacent a bottom surface of the thermally conductive material (202; 302).

3. The heat sink (300) of claim 2, wherein a first end of the at least one heat pipe (318) extends upwards through the thermally conductive material (302).

4. The heat sink (300) of claim 3, wherein:
the first end of the at least one heat pipe (318) extends upwards at approximately a ninety degree angle from a main portion of the at least one heat pipe (318); or
the first end of the at least one heat pipe (318) extends upwards through the thermally conductive material (302) adjacent a side of the thermally conductive material (302); or
the at least one heat pipe (318) extends upwards through the thermally conductive material (302) at a second end of the heat pipe (318), the second end opposite the first end of the heat pipe (318).

5. The heat sink (300) of claim 3, wherein the first end of the at least one heat pipe (318) is positioned to receive direct air flow from the impingement fan (304).

6. The heat sink (300) of claim 3, wherein the at least one heat pipe (318) does not protrude beyond an exterior of the at least one thermally conductive material (302).

7. The heat sink (200; 300) of claim 1, wherein the at least one heat pipe (218; 318) is disposed at about a forty-five degree angle horizontally inside the thermally conductive material (202; 302) relative to at least one side of the thermally conductive material (302).

8. The heat sink (200; 300) of any one of the preceding claims, wherein the at least one heat pipe (218; 318) includes heat pipes positioned such that at least a portion of each of the heat pipes is adjacent at least one of the edges of the thermally conductive material (202; 302) having the increased air flow from the impingement fan (204; 304).

9. The heat sink (200; 300) of any one of the preceding claims, wherein:
the impingement fan (204; 304) is configured to direct air downwards toward a top surface of the thermally conductive material (202; 302) such that the first and second sections of the thermally conductive material (202; 302) having the increased air flow are adjacent edges of the thermally conductive material (202; 302) where the impingement fan (204; 304) releases air in the rotation direction of the impingement fan (204; 304); and
all of the at least one heat pipe (218; 318) is entirely disposed within the thermally conductive material (202; 302).

10. The heat sink (200; 300) of any one of the preceding claims, wherein:
all of the at least one heat pipe (218; 318) is positioned entirely within the thermally conductive material (202; 302) adjacent the at least one thermoelectric module (216; 316) to transfer heat from the thermoelectric module (216; 316) to other portions of the thermally conductive material (202; 302); and
the at least one thermoelectric module (216; 316) is coupled to a side of the thermally conductive material (202; 302) opposite the impingement fan (204; 304).

11. A method of making a heat sink (200; 300), the method comprising:
positioning an impingement fan (204; 304) relative to a top surface or a bottom surface of a thermal plate having extruded fins or skived fins, such that the impingement fan (204; 304) will direct air downwards toward the top surface of the thermal plate so that air flow of the impingement fan (204; 304) is redirected, from a downward direction, horizontally across the thermal plate, thereby providing the air flow horizontally across the thermal plate with a non-uniform distribution and increased air flow across opposite first and second sections of the surface of the thermal plate that are in a rotation direction of the impingement fan (204; 304);
coupling a thermoelectric module (216; 316) to the thermal plate; and
positioning substantially all of at least one heat pipe (218; 318) within the bottom plate of the thermal plate at an angle horizontally towards the first and second sections of the thermal plate receiving an increased air flow from the impingement fan (204; 304), wherein the at least one heat pipe (218; 318) includes opposite first and second end portions adjacent to the first and second sections, respectively, of the thermal plate having the increased air flow from the impingement fan (204; 304), thereby allowing the at least one heat pipe (218; 318) to spread heat to the first and second sections of the thermal plate having the increased air flow and reduce thermal resistance of the heat sink (200; 300).

12. The method of claim 11, further comprising bending a first end of the at least one heat pipe (218; 318) to extend vertically through the thermal plate.

13. The method of claim 12, further comprising bending a second end of the at least one heat pipe (218; 318) to extend vertically through the thermal plate, the second end of the at least one heat pipe (218; 318) opposite the first end of the at least one heat pipe (218; 318).

14. The method of any one of claims 11 to 13, wherein:
positioning the at least one heat pipe (218; 318) includes positioning the at least one heat pipe (218; 318) at approximately a forty-five degree angle horizontally inside the thermal plate relative to a side of the thermal plate.

15. A method of using the heat sink (200; 300) of any one of claims 1 to 10, the method including rotating the impingement fan (204; 304) to direct the increased air flow across the first and second sections of the thermally conductive material (202; 302) receiving the at least one heat pipe (218; 318), and less air flow across one or more other portions of the thermally conductive material (202; 302) that do not receive at least one angled heat pipe (218; 318).

## Patentansprüche

1. Kühlkörper (200, 300) umfassend:
mindestens ein wärmeleitendes Material (202, 302); mit einer Oberseite und einer Unterplatte, wobei das wärmeleitende Material (202; 302) extrudierte Rippen oder geschälte Rippen umfasst;
einen Aufprallventilator (204, 304), der konfiguriert ist, um einen Luftstrom nach unten zu dem wärmeleitenden Material (202, 302) zu lenken, so dass der Luftstrom des Aufprallventilators (204; 304) von unten mit einer ungleichmäßigen Verteilung horizontal über das wärmeleitende Material (202, 302) geleitet wird, so dass sich ein gegenüberlieger erster und ein zweiter Abschnitt des wärmeleitenden Materials (202; 302), die in einer Drehrichtung des Aufprallventilators (204; 304) liegen, mehr Luftgeschwindigkeit erhalten, um einen erhöhten Luftstrom des Aufprallventilators (204; 304) zu haben;
mindestens ein thermoelektrisches Modul (216; 316), das mit dem wärmeleitenden Material (202, 302) verbunden ist; und
mindestens ein Wärmerohr (218; 318), wobei im Wesentlichen das gesamte Wärmerohr (218; 318) innerhalb der Bodenplatte des wärmeleitenden Materials (202; 302) angeordnet ist, wobei das mindestens eine Wärmerohr (218; 318) horizontal zum ersten und zweiten Abschnitt des wärmeleitenden Materials (202; 302), das den erhöhten Luftstrom vom Aufprallventilator (204; 304) erfährt, angewinkelt ist,
wobei das mindestens eine Wärmerohr (218; 318) ein gegenüberliegendes erstes und zweites Ende, neben dem ersten bzw. zweiten Abschnitt des wärmeleitenden Materials (202; 302) mit dem erhöhten Luftstrom des Aufprallventilators (204; 304) aufweist,
wobei ermöglicht wird, dass das mindestens eine Wärmerohr (218; 318) Wärme auf den ersten und zweiten Abschnitt des wärmeleitenden Materials (202; 302) überträgt, dass den erhöhten Luftstrom und den verringerten Wärmewiderstand des Kühlkörpers (200; 300) hat.

2. Kühlkörper (200, 300) nach Anspruch 1, wobei das mindestens eine Wärmerohr (218, 318) neben einer Bodenfläche des wärmeleitenden Materials (202, 302) angeordnet ist.

3. Kühlkörper (300) nach Anspruch 2, wobei sich ein erstes Ende des mindestens einen Wärmerohrs (318) durch das wärmeleitende Material (302) nach oben erstreckt.

4. Kühlkörper (300) nach Anspruch 3, wobei:
sich das erste Ende des mindestens einen Wärmerohrs (318) in einem Winkel von ungefähr neunzig Grad von einem Hauptabschnitt des mindestens einen Wärmerohrs (318) nach oben erstreckt; oder
sich das erste Ende des mindestens einen Wärmerohrs (318) nach oben durch das wärmeleitende Material (302) neben einer Seite des wärmeleitenden Materials (302) erstreckt; oder
sich das mindestens eine Wärmerohr (318) an einem zweiten Ende des Wärmerohrs (318) durch das wärmeleitende Material (302) nach oben erstreckt, wobei das zweite Ende dem ersten Ende des Wärmerohrs (318) gegenüberliegt.

5. Kühlkörper (300) nach Anspruch 3, wobei das erste Ende des mindestens einen Wärmerohrs (318) so positioniert ist, dass es einen direkten Luftstrom vom Aufprallventilator (304) erhält.

6. Kühlkörper (300) nach Anspruch 3, wobei das mindestens eine Wärmerohr (318) nicht über eine Außenseite des mindestens einen wärmeleitenden Materials (302) hinausragt.

7. Kühlkörper (200, 300) nach Anspruch 1, wobei das mindestens eine Wärmerohr (218, 318) horizontal in dem wärmeleitenden Material (202, 302), in einem Winkel von etwa 45 Grad relativ zu mindestens einer Seite des wärmeleitenden Materials (302) angeordnet ist.

8. Kühlkörper (200, 300) nach einem der vorhergehenden Ansprüche, wobei das mindestens eine Wärmerohr (218, 318) Wärmerohre umfasst, die so positioniert sind, dass mindestens ein Teil jedes der Wärmerohre neben mindestens einem der Ränder des wärmeleitenden Materials (202, 302) liegt, das den erhöhten Luftstrom vom Aufprallventilator (204, 304) erhält.

9. Kühlkörper (200, 300) nach einem der vorhergehenden Ansprüche, wobei:
der Aufprallventilator (204, 304), der konfiguriert ist, um Luft nach unten zu einer oberen Oberfläche des wärmeleitenden Materials (202, 302) zu leiten, so dass die ersten und zweiten Abschnitte des wärmeleitenden Materials (202; 302), die den erhöhten Luftstrom haben, benachbarte Kanten des wärmeleitenden Materials (202; 302) sind, an denen der Aufprallventilator (204; 304) in Drehrichtung des Aufprallventilators (204; 304) Luft abgibt; und
das gesamte mindestens eine Wärmerohr (218; 318) ist vollständig in dem wärmeleitenden Material (202; 302) angeordnet.

10. Kühlkörper (200; 300) nach einem der vorhergehenden Ansprüche, wobei:
das gesamte mindestens eine Wärmerohr (218; 318) vollständig innerhalb des wärmeleitenden Materials (202, 302), neben dem mindestens einen thermoelektrischen Modul (216; 316), um Wärme vom thermoelektrischen Modul (216; 316) auf andere Teile des wärmeleitenden Materials (202; 302) zu übertragen, positioniert ist; und
das mindestens eine thermoelektrische Modul (216; 316) mit einer Seite des wärmeleitenden Materials (202; 302) gekoppelt ist

11. Verfahren zur Herstellung eines Kühlkörpers (200; 300), wobei das Verfahren umfasst:
Positionieren eines Aufprallventilators (204; 304) relativ zu einer oberen Oberfläche oder einer unteren Oberfläche einer Wärmeplatte mit extrudierten Rippen oder geschälten Rippen, so dass der Aufprallventilator (204; 304) Luft nach unten in Richtung der Oberseite der Wärmeplatte leiten, so dass der Luftstrom des Aufprallventilators (204; 304) von unten horizontal über die Wärmeplatte in einer ungleichmäßigen Verteilung geleitet wird und erhöhten Luftstrom über gegenüberliegende erste und zweite Abschnitte der Oberfläche der Wärmeplatte, die sich in Drehrichtung des Aufprallventilators (204; 304) befinden, bereitstellt;
Verbinden eines thermoelektrischen Moduls (216; 316) an die Wärmeplatte; und
Positionieren von im Wesentlichen allen mindestens einem Wärmerohr (218; 318) innerhalb der Bodenplatte der Wärmeplatte in einem Winkel horizontal zum ersten und zweiten Abschnitt der Wärmeplatte, die einen erhöhten Luftstrom von dem Aufprallventilator (204; 304) erhält, wobei das mindestens eine Wärmerohr (218; 318) gegenüberliegende erste und zweite Endabschnitte neben dem ersten und jeweils zweite Abschnitt der Wärmeplatte mit dem erhöhten Luftstrom aus dem Aufprallventilator (204; 304) umfasst, wodurch das mindestens eine Wärmerohr (218; 318) Wärme zu dem ersten und zweiten Abschnitt der Wärmeplatte mit dem erhöhten Luftstrom und reduzieren Wärmewiderstand des Kühlkörpers (200; 300) verteilen kann.

12. Verfahren nach Anspruch 11, ferner umfassend das Biegen eines ersten Endes des mindestens einen Wärmerohrs (218; 318), um sich vertikal durch die Wärmeplatte zu erstrecken.

13. Verfahren nach Anspruch 12, ferner umfassend das Biegen eines zweiten Endes des mindestens einen Wärmerohrs (218; 318)" um sich vertikal durch die Wärmeplatte zu erstrecken, wobei das zweite Ende des mindestens einen Wärmerohrs (218; 318), dem ersten Ende des mindestens einen Wärmerohrs (218; 318), gegenüberliegt.

14. Verfahren nach einem der Ansprüche 11 bis 13, wobei:
Positionieren des mindestens einen Wärmerohrs (218; 318), das horizontale Positionieren des mindestens einen Wärmerohrs (218; 318) in einem Winkel von ungefähr 45 Grad in der Wärmeplatte relativ zu einer Seite der Wärmeplatte umfasst.

15. Verfahren zur Verwendung des Kühlkörpers (200; 300) nach einem der Ansprüche 1 bis 10, wobei das Verfahren das Drehen des Aufprallventilators (204; 304) umfasst, um den erhöhten Luftstrom über die ersten und die zweiten Abschnitte des wärmeleitenden Materials (202; 302) zu leiten, die das mindestens eine Wärmerohr (218; 318) aufnimmt, und weniger Luftstrom über einen oder mehrere andere Teile des wärmeleitenden Materials (202; 302) zu leiten, die nicht das mindestens eine angewinkelte Wärmerohr (218) erhalten.

## Revendications

1. Dissipateur thermique (200 ; 300) comprenant :
au moins un matériau thermiquement conducteur (202 ; 302) ayant une surface supérieure et une plaque inférieure, le matériau thermiquement conducteur (202 ; 302) comprenant des ailettes extrudées ou des ailettes biseautées ;
un ventilateur à impact (204 ; 304) configuré pour diriger l'air vers le bas vers la surface supérieure du matériau thermiquement conducteur (202 ; 302) de sorte que le flux d'air du ventilateur à impact (204 ; 304) soit redirigé, d'une direction vers le bas, horizontalement en travers du matériau thermiquement conducteur (202 ; 302), fournissant ainsi le flux d'air horizontalement en travers du matériau thermiquement conducteur (202 ; 302) avec une distribution non uniforme de telle sorte que des première et seconde sections opposées du matériau thermiquement conducteur (202 ; 302) qui sont dans un sens de rotation du ventilateur à impact (204 ; 304) reçoivent plus de vitesse d'air pour avoir un flux d'air accru du ventilateur à impact (204 ; 304) ;
au moins un module thermoélectrique (216; 316) couplé au matériau thermiquement conducteur (202 ; 302) ; et
au moins un caloduc (218 ; 318), la quasi-totalité du caloduc (218 ; 318) étant disposé à l'intérieur de la plaque inférieure du matériau thermiquement conducteur (202 ; 302), l'au moins un caloduc (218 ; 318) étant disposé en angle horizontalement vers les première et seconde sections du matériau thermiquement conducteur (202 ; 302) ayant le flux d'air accru du ventilateur à impact (204 ; 304),
dans lequel l'au moins un caloduc (218; 318) comprend des première et seconde parties d'extrémité opposées adjacentes aux première et seconde sections, respectivement, du matériau thermiquement conducteur (202 ; 302) ayant le flux d'air accru du ventilateur à impact (204 ; 304), permettant ainsi à l'au moins un caloduc (218 ; 318) de répartir de la chaleur vers les première et seconde sections du matériau thermiquement conducteur (202 ; 302) ayant le flux d'air accru et de réduire la résistance thermique du dissipateur thermique (200 ; 300).

2. Dissipateur thermique (200; 300) selon la revendication 1, dans lequel l'au moins un caloduc (218 ; 318) est disposé adjacent à une surface inférieure du matériau thermiquement conducteur (202 ; 302).

3. Dissipateur thermique (300) selon la revendication 2, dans lequel une première extrémité de l'au moins un caloduc (318) s'étend vers le haut à travers le matériau thermiquement conducteur (302).

4. Dissipateur thermique (300) selon la revendication 3, dans lequel :
la première extrémité de l'au moins un caloduc (318) s'étend vers le haut à un angle d'environ quatre-vingt-dix degrés à partir d'une partie principale de l'au moins un caloduc (318) ; ou
la première extrémité de l'au moins un caloduc (318) s'étend vers le haut à travers le matériau thermiquement conducteur (302) adjacent à un côté du matériau thermiquement conducteur (302) ; ou
l'au moins un caloduc (318) s'étend vers le haut à travers le matériau thermiquement conducteur (302) à une seconde extrémité du caloduc (318), la seconde extrémité opposée à la première extrémité du caloduc (318).

5. Dissipateur thermique (300) selon la revendication 3, dans lequel la première extrémité de l'au moins un caloduc (318) est positionnée pour recevoir un flux d'air direct du ventilateur à impact (304).

6. Dissipateur thermique (300) selon la revendication 3, dans lequel l'au moins un caloduc (318) ne dépasse pas au-delà d'un extérieur de l'au moins un matériau thermiquement conducteur (302).

7. Dissipateur thermique (200; 300) selon la revendication 1, dans lequel l'au moins un caloduc (218; 318) est disposé à un angle d'environ 45 degrés horizontalement à l'intérieur du matériau thermiquement conducteur (202 ; 302) par rapport à au moins un côté du matériau thermiquement conducteur (302).

8. Dissipateur thermique (200 ; 300) selon l'une quelconque des revendications précédentes, dans lequel l'au moins un caloduc (218; 318) comprend des caloducs positionnés de telle sorte qu'au moins une partie de chacun des caloducs est adjacente à au moins l'un des bords du matériau thermiquement conducteur (202 ; 302) ayant le flux d'air accru du ventilateur à impact (204 ; 304).

9. Dissipateur thermique (200 ; 300) selon l'une quelconque des revendications précédentes, dans lequel :
le ventilateur à impact (204 ; 304) est configuré pour diriger l'air vers le bas vers une surface supérieure du matériau thermiquement conducteur (202 ; 302) de telle sorte que les première et seconde sections du matériau thermiquement conducteur (202 ; 302) ayant le flux d'air accru sont des bords adjacents du matériau thermiquement conducteur (202 ; 302) où le ventilateur à impact (204 ; 304) évacue de l'air dans le sens de rotation du ventilateur à impact (204 ; 304) ; et
tout l'au moins un caloduc (218 ; 318) est entièrement disposé à l'intérieur du matériau thermiquement conducteur (202 ; 302).

10. Dissipateur thermique (200 ; 300) selon l'une quelconque des revendications précédentes, dans lequel :
tout l'au moins un caloduc (218 ; 318) est positionné entièrement à l'intérieur du matériau thermiquement conducteur (202 ; 302) adjacent à l'au moins un module thermoélectrique (216; 316) pour transférer de la chaleur du module thermoélectrique (216; 316) à d'autres parties du matériau thermiquement conducteur (202 ; 302) ; et
l'au moins un module thermoélectrique (216; 316) est couplé à un côté du matériau thermiquement conducteur (202 ; 302) opposé au ventilateur à impact (204 ; 304).

11. Procédé de fabrication d'un dissipateur thermique (200; 300), le procédé comprenant :
positionner un ventilateur à impact (204 ; 304) par rapport à une surface supérieure ou à une surface inférieure d'une plaque thermique ayant des ailettes extrudées ou des ailettes biseautées, de telle sorte que le ventilateur à impact (204 ; 304) dirigera l'air vers le bas en direction de la surface supérieure de la plaque thermique de sorte que le flux d'air du ventilateur à impact (204 ; 304) soit redirigé, à partir d'une direction vers le bas, horizontalement en travers de la plaque thermique, fournissant ainsi le flux d'air horizontalement en travers de la plaque thermique avec une distribution non uniforme et un flux d'air accru en travers des première et seconde sections opposées de la surface de la plaque thermique qui sont dans un sens de rotation du ventilateur à impact (204 ; 304) ;
coupler un module thermoélectrique (216 ; 316) à la plaque thermique; et
positionner sensiblement la totalité d'au moins un caloduc (218 ; 318) à l'intérieur de la plaque inférieure de la plaque thermique à un angle horizontal vers les première et seconde sections de la plaque thermique recevant un flux d'air accru du ventilateur à impact (204 ; 304), dans lequel l'au moins un caloduc (218 ; 318) comprend des première et seconde parties d'extrémité opposées adjacentes aux première et seconde sections, respectivement, de la plaque thermique ayant le flux d'air accru du ventilateur à impact (204 ; 304), permettant ainsi à l'au moins un caloduc (218 ; 318) de répartir de la chaleur vers les première et seconde sections de la plaque thermique ayant le flux d'air accru et de réduire la résistance thermique du dissipateur thermique (200 ; 300).

12. Procédé selon la revendication 11, comprenant en outre le fait de plier une première extrémité de l'au moins un caloduc (218 ; 318) pour qu'elle s'étende verticalement à travers la plaque thermique.

13. Procédé selon la revendication 12, comprenant en outre le fait de plier une seconde extrémité de l'au moins un caloduc (218 ; 318) pour qu'elle s'étende verticalement à travers la plaque thermique, la seconde extrémité de l'au moins un caloduc (218 ; 318) opposée à la première extrémité de l'au moins un caloduc (218 ; 318).

14. Procédé selon l'une quelconque des revendications 11 à 13, dans lequel : positionner l'au moins un caloduc (218 ; 318) comprend positionner l'au moins un caloduc (218 ; 318) à un angle d'environ 45 degrés horizontalement à l'intérieur de la plaque thermique par rapport à un côté de la plaque thermique.

15. Procédé d'utilisation du dissipateur thermique (200 ; 300) selon l'une quelconque des revendications 1 à 10, le procédé comprenant la rotation du ventilateur à impact (204 ; 304) pour diriger le flux d'air accru en travers des première et seconde sections du matériau thermiquement conducteur (202 ; 302) recevant l'au moins un caloduc (218 ; 318), et moins de flux d'air en travers d'une ou plusieurs autres parties du matériau thermiquement conducteur (202 ; 302) qui ne reçoivent pas au moins un caloduc disposé en angle (218 ; 318).
